(19) Europäisches Patentamt
European Patent Office
Office européen des brevets

(11) **EP 3 426 895 B1**

(12) **EUROPÄISCHE PATENTSCHRIFT**

(45) Veröffentlichungstag und Bekanntmachung des Hinweises auf die Patenterteilung:
**05.02.2020 Patentblatt 2020/06**

(51) Int Cl.:
***F01D 5/16*** *(2006.01)*        ***G06F 17/50*** *(2006.01)*

(21) Anmeldenummer: **17717160.0**

(22) Anmeldetag: **12.04.2017**

(86) Internationale Anmeldenummer:
**PCT/EP2017/058776**

(87) Internationale Veröffentlichungsnummer:
**WO 2017/186492 (02.11.2017 Gazette 2017/44)**

(54) **VERFAHREN ZUM PROFILIEREN VON SCHAUFELN EINER AXIALSTRÖMUNGSMASCHINE**

METHOD FOR PROFILING BLADES OF AN AXIAL TURBOMACHINE

PROCÉDÉ DE PROFILAGE D'AUBES D'UNE TURBOMACHINE AXIALE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.04.2016 EP 16167260**

(43) Veröffentlichungstag der Anmeldung:
**16.01.2019 Patentblatt 2019/03**

(73) Patentinhaber: **Siemens Aktiengesellschaft 80333 München (DE)**

(72) Erfinder:
• **PEEREN, Christian**
  **10245 Berlin (DE)**
• **SCHMITT, Stefan**
  **45481 Mülheim an der Ruhr (DE)**
• **STÜER, Heinrich**
  **45721 Haltern (DE)**

(56) Entgegenhaltungen:
**EP-A2- 1 528 223        US-A1- 2010 050 594
US-A1- 2014 112 760**

**Beschreibung**

Die Erfindung betrifft ein Verfahren zum Profilieren von Schaufeln einer Axialströmungsmaschine.

Der Trend bei der Auslegung von Schaufeln für eine Axialströmungsmaschine geht dahin, das Aspektverhältnis der Schaufeln zu erhöhen und die Schaufeln dünner auszuführen. Die derart ausgelegten Schaufeln neigen dazu im Betrieb der Axialströmungsmaschine zu flattern. Bei dem Flattern handelt es sich um eine selbsterregte Schwingung bei der Eigenfrequenz der Schaufel. Bei dieser Schwingung kann es sich um eine Longitudinalschwingung der Schaufel mit einem Schwingungsknoten an dem Fuß der Schaufel handeln. Dabei wird Energie von dem in der Axialströmungsmaschine strömenden Fluid auf die Schaufel übertragen. Das Flattern kann bei einem wiederholten Lastwechsel der Axialströmungsmaschine zu einer Materialermüdung der Schaufel führen (englisch: high cycle fatigue). Die Materialermüdung kann zu der Bildung eines Risses führen und einen kostenintensiven Tausch der Schaufel erforderlich machen.

Herkömmlich wird das Flattern unterbunden, indem die auf die Schaufel wirkende Last vermindert wird. Dies führt jedoch nachteilig zu einer Verminderung des Wirkungsgrades der Axialströmungsmaschine. Außerdem werden herkömmlich Dämpfungselemente vorgesehen, wie beispielsweise ein Deckband, was das Flattern der Schaufeln dämpft. Dies stellt jedoch eine konstruktiv aufwändige Lösung dar. Daher wäre es wünschenswert die Schaufel derart auszulegen, dass sie im Betrieb der Axialströmungsmaschine nicht zum Flattern neigt.

Herkömmlich wird die Schaufel derart ausgelegt, dass in einem Vorauslegungsverfahren zuerst ein Schaufelprofil hinsichtlich der reduzierten Frequenz und des 0D Strouhal Kriteriums bewertet wird. Nach dem Vorauslegungsverfahren werden die akzeptierten Schaufelprofile in einer aufwändigen numerischen Schwingungssimulation bewertet. Die anhand der reduzierten Frequenz und des Strouhal Kriteriums bewerteten akzeptierten Schaufelprofile weisen jedoch in der Schwingungssimulation oftmals ein unakzeptables Flatterverhalten auf. Dies führt dazu, dass für viele verschiedene Schaufelprofile das Vorauslegungsverfahren und die numerische Schwingungssimulation wiederholt werden muss, was zeitaufwändig und kostenintensiv ist.

Daneben ist aus der EP 1 528 223 A2 ein Verfahren zum Entwurf von Laufschaufeln bekannt, bei dem eine quantitative Eigenschaft für einen ersten Entwurf eines Schaufelblatts ermittelt wird. Die quantitative Eigenschaft entspricht einem Maß für die Korrelation zwischen der Erregungskraft, der die Schaufel im Gebrauch unterworfen ist, und einem Schwingungsmodus der Schaufel, welcher einer charakteristischen Frequenz der Erregung entspricht. Anschließend wird das Schaufelblatt geringfügig modifiziert, sodass für diesen zweiten Entwurf erneut die quantitative Eigenschaft bestimmbar ist. Dabei werden solche Modifikationen als vorteilhaft erachtet, bei denen die Korrelation zwischen der Erregungskraft und der charakteristischen Frequenz der Erregung weiter reduziert ist.

Aufgabe der Erfindung ist es daher, ein Verfahren zum Profilieren einer Schaufel einer Axialströmungsmaschine zu schaffen, welches wenig zeitaufwändig und wenig kostenintensiv ist.

Das erfindungsgemäße Verfahren zum Profilieren von Schaufeln einer Axialströmungsmaschine weist die Schritte auf: a) Bereitstellen eines geometrischen Modells eines Schaufelprofils; b) Ermitteln einer Schwingungsform des geometrischen Modells; c) Berechnen eines zeitlichen Verlaufs eines ortsabhängigen Stördrucks $p(\vec{x},t)=p_{ges}(\vec{x},t) -p_0(\vec{x})$ in einem Kanal zwischen zwei benachbart angeordneten Schaufelprofilen über eine Schwingungsperiode der zu der Schwingungsform gehörigen Schwingung, wobei zum Berechnen des Verlaufs angenommen wird, dass der ortsabhängige Stördruck $p(\vec{x},t)$ in dem Kanal proportional zu der Größe einer Fläche $A(\vec{x},t)$ ist, die in dem Kanal sich erstreckt und auf den zwei den Kanal begrenzenden Schaufeloberflächen senkrecht zu diesen Schaufeloberflächen und dazwischen senkrecht zu den Strömungslinien angeordnet ist, wobei $\vec{x}$ eine Koordinate auf einer der zwei Schaufeloberflächen, t die Zeit, $p_0(\vec{x})$ der ortsabhängige Druck bei still stehenden Schaufelprofilen und $p_{ges}(\vec{x},t)$ der ortsabhängige Gesamtdruck ist; d) Bestimmen der durch den Stördruckverlauf hervorgerufenen Dämpfung der Schwingung; d) Verändern des geometrischen Modells und ermitteln einer veränderten Schwingungsform für das veränderte geometrische Modell sowie Durchführen von Schritt c) mit dem veränderten geometrischen Modell und der veränderten Schwingungsform; e) Bestimmen der Dämpfung der Schwingung durch den in Schritt d) berechneten Stördruckverlauf $p(\vec{x},t)$ und Akzeptieren des veränderten geometrischen Modells für den Fall, dass die Dämpfung der Schwingung stärker als in Schritt c) ausfällt, ansonsten Wiederholen der Schritte d) und e) mit einem anderen veränderten geometrischen Modell.

Insbesondere aufgrund der Annahme, dass der Stördruck in dem Kanal proportional zu der Fläche $A(\vec{x},t)$ ist, ist das Verfahren wenig rechenintensiv. Die Annahme ist gültig für unendlich langsam schwingende Schaufelprofile. Überraschenderweise wurde trotz dieser Annahme gefunden, dass das akzeptierte geometrische Modell in einer anschließenden numerischen Schwingungssimulation gute Dämpfungseigenschaften zeigt. Daher ist es nicht erforderlich eine große Anzahl an den numerischen Schwingungssimulationen durchzuführen. Aufgrund des wenig rechenintensiven Verfahrens und der geringen Anzahl an den durchzuführenden numerischen Schwingungssimulationen ist das Verfahren vorteilhaft wenig aufwändig und wenig kostenintensiv.

Bevorzugt weist das Verfahren den Schritt auf: f) Numerisches Berechnen der anhand einer Strömung hervorgerufenen Schwingung des in Schritt e) akzeptierten geometrischen Modells und Berechnen der Dämpfung der Schwingung. Bei dem Verfahrensschritt f) handelt es um die vorgenannte numerische Schwingungssimulation. Die hier berechnete Dämpfung der Schwingung ist genauer als die in dem Verfahrensschritt d) bestimmte. Es ist hierbei bevorzugt, dass in dem Schritt f) die Konvektion und die Trägheit der Strömung berücksichtigt werden. Dadurch kann die Genauigkeit bei der Bestimmung der Dämpfung noch weiter gesteigert werden.

Es ist bevorzugt, dass die Schwingungsform in komplexer Form dargestellt wird: $\vec{\phi} = \vec{a}_c + i\vec{a}_s$, wobei $\vec{\phi}$ die Schwingungsform ist, $\vec{a}_c$ und $\vec{a}_s$ lokale Verformungen sind. Es ist hierbei bevorzugt, dass $\vec{a}_c$ und $\vec{a}_s$ mittels eines Finiten Elemente Strukturlösers bereitgestellt werden.

Es ist bevorzugt, dass $A(\vec{x},t)$ dargestellt wird gemäß $A(\vec{x},t) = A_0(\vec{x}) + \mathrm{Re}[(\hat{A}_1 e^{i\beta_1} e^{i\sigma} + \hat{A}_R e^{i\beta_R})e^{i\omega t}]$, wobei $A_0(\vec{x})$ die Fläche $A(\vec{x},t)$ bei still stehenden Schaufelprofilen, $\hat{A}_R = |\vec{n}_R \cdot \vec{\phi}|_R$ die Projektion der Schwingungsform auf die Normale $\vec{n}_R$ der Schaufeloberfläche bei der Koordinate $\vec{x}$ für das eine Schaufelprofil, $\hat{A}_1 = |\vec{n}_1 \cdot \vec{\phi}|_1$ die Projektion der Schwingungsform auf die Normale $\vec{n}_1$ der Schaufeloberfläche bei einem Punkt auf der Schaufeloberfläche des anderen Schaufelprofils, $\beta_1$ und $\beta_R$ der jeweilige Phasenversatz zwischen dem Imaginärteil und dem Realteil, $\sigma$ der Phasenversatz der Schwingungen der beiden Schaufelprofile und $\omega$ die Kreisfrequenz ist. Dies beinhaltet als Näherung, dass sich das Schaufelprofil während der Schwingung senkrecht zu seiner Schaufeloberfläche bewegt. Diese Näherung ist insbesondere gültig bei kleinen Auslenkungen der Schaufel während ihrer Schwingung. Durch diese Näherung ist das Verfahren vorteilhaft wenig rechenintensiv. Trotz dieser Näherung hat das akzeptierte geometrische Modell vorteilhaft gute Dämpfungseigenschaften.

Es ist bevorzugt, dass $A_0(\vec{x})$ bestimmt wird, indem bei der Koordinate $\vec{x}$ auf der Schaufeloberfläche des einen Schaufelprofils ein Kreis gefunden wird, der die Schaufeloberfläche des einen Schaufelprofils bei der Koordinate $\vec{x}$ und die Schaufeloberfläche des anderen Schaufelprofils in dem Punkt tangiert, und $A_0(\vec{x})$ derart gewählt wird, dass $A_0(\vec{x})$ von der Normalen $\vec{n}_R$ bei der Koordinate $\vec{x}$ und von der Normalen $\vec{n}_1$ an dem Punkt tangiert wird. Dies stellt vorteilhaft einen einfachen Verfahrensschritt zum Bestimmen der Fläche $A_0(\vec{x})$ dar. Zusammen mit der Annahme, dass die Schaufelprofile sich während der Schwingung normal zur Schaufeloberfläche bewegen, ist die zeitliche Änderung der Fläche $A_0(\vec{x},t)$ genau definiert. $A_0(\vec{x})$ wird bevorzugt bestimmt durch Interpolieren einer Funktion, insbesondere ein Polynom zweiten Grades, zwischen der Koordinate $\vec{x}$ und dem Punkt. Dies stellt ein besonders einfaches Verfahren zum Bestimmen der Fläche $A_0(\vec{x})$ dar. Beispielsweise ist es dadurch nicht erforderlich eine Strömungssimulation zum Bestimmen der Strömungslinien durchzuführen.

Trotz dieses einfachen Verfahrens zum Bestimmen der Fläche $A_0(\vec{x})$ hat das akzeptierte geometrische Modell vorteilhaft gute Dämpfungseigenschaften.

Es ist bevorzugt, dass in Schritt d) die Dämpfung der Schwingung für verschiedene Werte für $\beta_1$, $\beta_R$ und $\sigma$ bestimmt wird. Dadurch lässt sich die Zeitabhängigkeit der Fläche $A_0(\vec{x},t)$ bestimmen. Ferner ist es bevorzugt, dass in Schritt d) eine Integration des ortsabhängigen Stördrucks entlang des vollständigen Kanals vorgenommen wird.

Im Folgenden wird anhand der beigefügten schematischen Zeichnungen die Erfindung näher erläutert. Es zeigen

Figur 1 einen Querschnitt durch drei benachbart angeordnete Schaufeln,

Figur 2 ein Detail aus Figur 1,

Figur 3 eine Darstellung eines Kanals zwischen zwei benachbart angeordneten Schaufeln,

Figur 4 eine Darstellung einer Schwingungsform einer Schaufel und

Figur 5 einen Dämpfungsverlauf über eine Schwingungsperiode für verschiedene reduzierte Frequenzen.

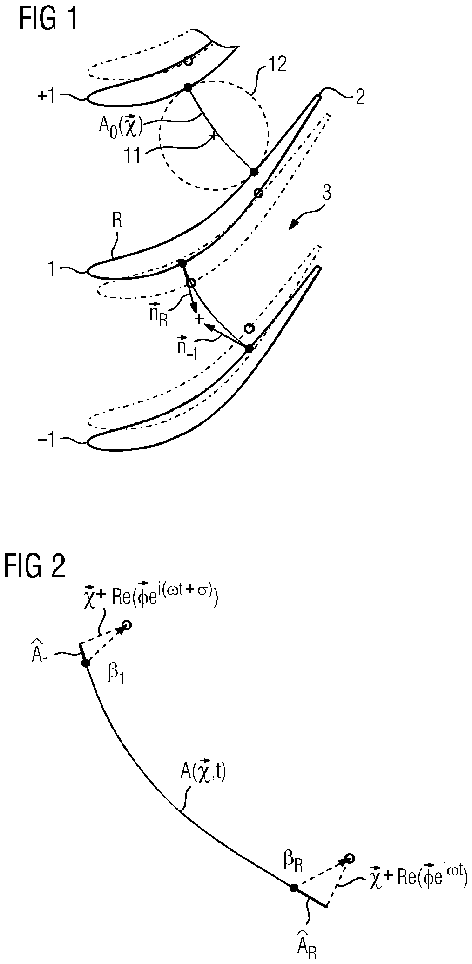

Eine Axialströmungsmaschine, wie beispielsweise eine Gasturbine oder eine Dampfturbine, weist Reihen von Schaufeln auf. Bei den Schaufeln kann es sich um Leitschaufeln und/oder Laufschaufeln handeln, die in einem Verdichter und/oder in einer Turbine angeordnet sind. Figur 1 zeigt drei in einer Reihe benachbart angeordnete Schaufeln. Dargestellt ist jeweils ein geometrisches Modell eines Schaufelprofils für jede der drei Schaufeln. Das mittlere Schaufelprofil ist als ein Referenzschaufelprofil R und die beiden zu dem Referenzschaufelprofil R benachbarten Schaufelprofile sind als ein erstes benachbartes Schaufelprofil +1 und als ein zweites benachbartes Schaufelprofil -1 bezeichnet. Jedes der Schaufelprofile R, -1, +1 weist jeweils eine Vorderkante 1 und eine Hinterkante 2 auf. Zwischen zwei benachbart angeordneten Schaufelprofilen ist jeweils ein Kanal 3 angeordnet, in dem im Betrieb der Axialströmungsmaschine ein Arbeitsfluid strömt. Die durchgezogenen Linien in Figur 1 stellen die Schaufelprofile R, +1, -1 in ihrem still stehenden Zustand dar. Die gestrichelten Linien stellen die Schwingung der Schaufelprofile R, +1, -1 dar, wobei das erste benachbarte Schaufelprofil +1 und das zweite benachbarte Schaufelprofil -1 eine gleiche Schwingungsphase haben, die zu der Schwingungsphase des Referenzschaufelprofils R versetzt ist.

In dem Verfahren zum Profilieren der Schaufel wird in einem Schritt a) das geometrische Modell des Schaufelprofils R, -1, +1 bereitgestellt, wobei die Schaufelprofile R, -1, +1 in einer Reihe von Schaufeln identisch sind.

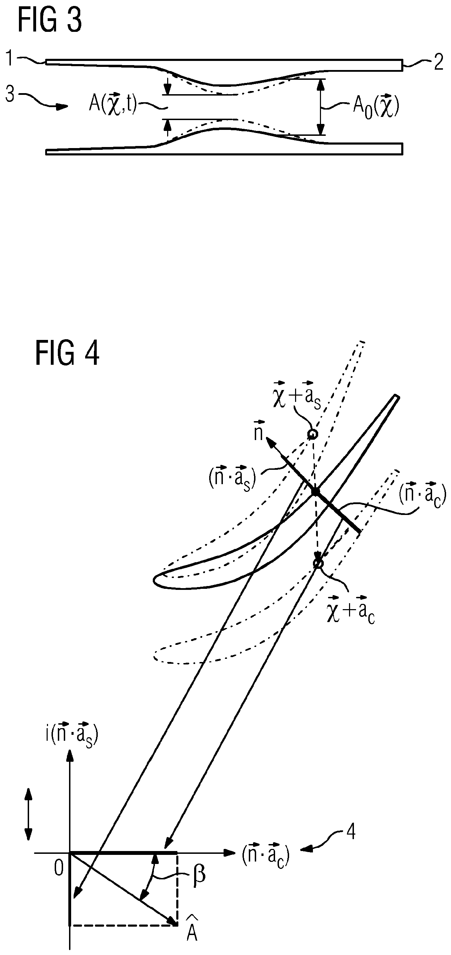

In einem Schritt b) wird die Schwingungsform $\vec{\phi}$ des geometrischen Modells ermittelt. Wie es aus Figur 4 ersichtlich ist, kann die Schwingungsform $\vec{\phi}$ in komplexer Form gemäß $\vec{\phi} = \vec{a}_c + i\vec{a}_s$ dargestellt werden, wobei $\vec{a}_c$ und $\vec{a}_s$ lokale Verformungen sind. Die Schwingungsform ergibt sich dann als Überlagerung dieser beiden Formen. In Figur 4 ist diese Überlagerung in einem Zeigerdiagramm 4 dargestellt, wobei der Phasenversatz zwischen Realteil und Imaginärteil mit $\beta$ bezeichnet ist. $\vec{a}_c$ und $\vec{a}_s$ können mittels eines Finite Elemente Strukturlösers bestimmt werden, wobei der Finite Elemente Strukturlöser als eine Eingabe das Schaufelprofil erhält.

In einem Schritt c) wird ein zeitlicher Verlauf eines ortsabhängigen Stördrucks $p(\vec{x},t)$ in dem Kanal 3 über eine Schwingungsperiode der zu der Schwingungsform gehörigen Schwingung berechnet. $\vec{x}$ ist dabei eine Koordinate auf der Oberfläche einer der beiden benachbarten Schaufelprofilen und t ist die Zeit. Zum Berechnen des Stördrucks $p(\vec{x},t)$ wird angenommen, dass der ortsabhängige Stördruck $p(\vec{x},t)$ in dem Kanal 3 proportional zu der Größe einer Fläche $A(\vec{x},t)$ ist, die in dem Kanal sich erstreckt und auf den den Kanal 3 begrenzenden Schaufeloberflächen senkrecht zu diesen Schaufeloberflächen und dazwischen senkrecht zu den Strömungslinien angeordnet ist.

Die Näherung, dass der Stördruck $p(\vec{x},t)$ als proportional zu der Fläche $A(\vec{x},t)$ angenommen wird, ist in Figur 3 illustriert. Die durchgezogenen Linien in Figur 3 stellen die zwei den Kanal 3 begrenzenden Schaufeloberflächen in ihrem still stehenden Zustand dar. Die gestrichelten Linien stellen die zwei den Kanal 3 begrenzenden Schaufeloberflächen mit einer Auslenkung während ihrer Schwingung dar. Bei einer kleinen Fläche $A(\vec{x},t)$ ist im Betrieb der Axialströmungsmaschine die Geschwindigkeit des Arbeitsfluids hoch, wodurch ein niedriger Stördruck $p(\vec{x},t)$ herrscht. Umgekehrt gilt analog, dass bei einer großen Fläche $A(\vec{x},t)$ im Betrieb der Axialströmungsmaschine die Geschwindigkeit des Arbeitsfluids niedrig ist, wodurch ein hoher Stördruck $p(\vec{x},t)$ herrscht.

$A(\vec{x},t)$ wird dargestellt gemäß $A(\vec{x},t) = A_0(\vec{x}) + \mathrm{Re}\lfloor(\hat{A}_1 e^{i\beta_1} e^{i\sigma} + \hat{A}_R e^{i\beta_R}) e^{i\omega t}\rfloor$, wobei $A_0(\vec{x})$ die Fläche $A(\vec{x},t)$ bei still stehenden Schaufelprofilen ist. $A_0(\vec{x})$ kann, wie in Figur 1 gezeigt, bestimmt werden, indem bei der Koordinate $\vec{x}$ auf der Schaufeloberfläche des einen Schaufelprofils ein Kreis 12 gefunden wird, der die Schaufeloberfläche des einen Schaufelprofils bei der Koordinate $\vec{x}$ und die Schaufeloberfläche des anderen Schaufelprofils in einem Punkt tangiert. Für den Fall, dass mehrere der Kreise 12 gefunden werden können, so wird der Kreis 12 mit dem kürzesten Durchmesser ausgewählt. $A_0(\vec{x})$ wird anschließend derart gewählt, dass $A_0(\vec{x})$ von der Normalen $\vec{n}_R$ auf der Oberfläche des einen Schaufelprofils bei der Koordinate $\vec{x}$ und von der Normalen $\vec{n}_1$ auf der Oberfläche des anderen Schaufelprofils an dem Punkt tangiert wird. Dazu wird $A_0(\vec{x})$ bestimmt durch Interpolieren einer Funktion zwischen der Koordinate $\vec{x}$ und dem Punkt. Beispielsweise kann die Funktion ein Polynom zweiten Grades sein. Wie es aus Figur 1 ersichtlich ist, weisen beide Normale $\vec{n}_R$ und $\vec{n}_1$ auf den Kreismittelpunkt 11 des Kreises 12, was eine Konsequenz davon ist, dass der Kreis 12 die beiden Schaufeloberflächen in der Koordinate $\vec{x}$ und dem Punkt tangiert.

$\hat{A}_R = |\vec{n}_R \cdot \vec{\phi}|_R$ ist die Projektion der Schwingungsform $\vec{\phi}$ auf die Normale $\vec{n}_R$ der Schaufeloberfläche bei der Koordinate $\vec{x}$ für das eine Schaufelprofil. $\hat{A}_1 = |\vec{n}_1 \cdot \vec{\phi}|_1$ ist die Projektion der Schwingungsform $\vec{\phi}$ auf die Normale $\vec{n}_1$ der Schaufeloberfläche bei dem Punkt auf der Schaufeloberfläche des anderen Schaufelprofils. Die jeweiligen Projektionen $\hat{A}_R$ und $\hat{A}_1$ sind in Figur 2 als die Linien von dem jeweiligen Punkt bis zum jeweiligen Ende der Linien dargestellt. $\beta_1$ und $\beta_R$ sind der jeweilige Phasenversatz zwischen dem Imaginärteil und dem Realteil. $\sigma$ ist der Phasenversatz der Schwingungen der beiden Schaufelprofile und $\omega$ ist die Kreisfrequenz.

In einem Schritt d) wird die durch den Stördruckverlauf hervorgerufenen Dämpfung der Schwingung bestimmt. Dazu wird der Stördruck mit der Projektion der Schwingungsform auf die Normale der Schaufeloberfläche multipliziert. Das dabei erhaltene Produkt wird über den gesamten Kanal 3 integriert, wodurch sich die Dämpfung ergibt.

In einem Schritt d) wird das geometrische Modell verändert und eine veränderte Schwingungsform für das veränderte geometrische Modell ermittelt. In dem Schritt d) wird zudem Schritt c) mit dem veränderten geometrischen Modell und der veränderten Schwingungsform durchgeführt.

In einem Schritt e) wird die Dämpfung der Schwingung durch den in Schritt d) berechneten Stördruckverlauf $p(\vec{x},t)$ bestimmt. Das verändertete geometrische Modell wird akzeptiert für den Fall, dass die Dämpfung der Schwingung stärker als in Schritt c) ausfällt, ansonsten werden die Schritte d) und e) mit einem anderen veränderten geometrischen Modell wiederholt.

In Schritt d) kann die Dämpfung der Schwingung für verschiedene Werte für $\beta_1$, $\beta_R$ und $\sigma$ bestimmt wird, so dass die Zeitabhängigkeit der Fläche $A(\vec{x},t)$ erhalten.

In einem Schritt f) erfolgt ein numerisches Berechnen der anhand einer Strömung hervorgerufenen Schwingung des in Schritt e) akzeptierten geometrischen Modells und ein Berechnen der Dämpfung der Schwingung.

Der in Schritt c) berechnete Stördruck $p(\vec{x},t)$ und die in Schritt d) berechnete Dämpfung stellen eine Näherung für den Fall $k \to 0$ dar, wobei $k$ die reduzierte Frequenz ist. Die reduzierte Frequenz kann bestimmt wer-

$$k = \frac{2 * \Pi * c * f}{U},$$

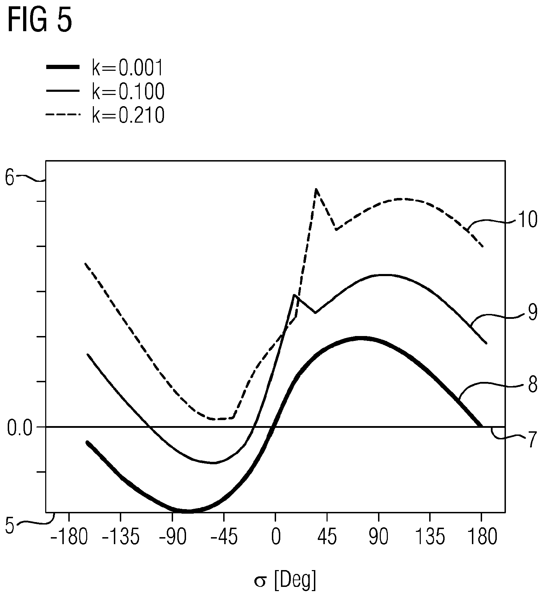

den gemäß wobei f die Frequenz der Schwingung, *c* die Sehnenlänge des Schaufelprofils und *U* die Geschwindigkeit des Arbeitsfluids in einer Axialposition der Strömungsmaschine, in der die Vorderkanten 1 der Schaufelprofile liegen, ist. In Figur 5 ist der in Schritt f) berechnete Dämpfungsverlauf über eine Schwingungsperiode für verschiedene reduzierte Frequenzen k dargestellt. Das dem Schritt f) zugrunde liegende geometrische Modell ist ein in dem Schritt e) akzeptiertes geometrisches Modell. Über der Abszisse 5 ist der Phasenwinkel $\sigma$ und über der Ordinate 6 ist die Dämpfung aufgetragen. Ebenfalls ist in Figur 5 eine Nulllinie 7 der Dämpfung eingetragen, wobei negative Werte für die Dämpfung eine Anregung der Schwingung bedeuten und positive Werte für die Dämpfung eine Dämpfung der Schwingung bedeuten.

Figur 5 weist einen Dämpfungswertverlauf 8 bei k=0,001, einen Dämpfungswertverlauf 9 bei k=0,1 und einen Dämpfungswertverlauf 10 bei k=0,21 auf. Der Dämpfungswertverlauf 8 ist aufgrund dessen geringer reduzierter Frequenz vergleichbar mit dem in dem Schritt d) bestimmten. Erkennbar ist, dass mit zunehmender reduzierter Frequenz die Dämpfung der Schwingung zunimmt. Das in Schritt e) akzeptierte geometrische Modell stellt damit einen guten Ausgangspunkt für die anschließende numerische Simulation der Schwingung dar.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

**Patentansprüche**

1. Verfahren zum Profilieren von Schaufeln einer Axialströmungsmaschine, mit den Schritten:

   a) Bereitstellen eines geometrischen Modells eines Schaufelprofils (R, -1, +1);
   b) Ermitteln einer Schwingungsform des geometrischen Modells;
   c) Berechnen eines zeitlichen Verlaufs eines ortsabhängigen Stördrucks $p(\vec{x}, t) = p_{ges}(\vec{x},t) - p_0(\vec{x})$ in einem Kanal (3) zwischen zwei benachbart angeordneten Schaufelprofilen über eine Schwingungsperiode der zu der Schwingungsform gehörigen Schwingung, wobei zum Berechnen des Verlaufs angenommen wird, dass der ortsabhängige Stördruck $p(\vec{x},t)$ in dem Kanal (3) proportional zu der Größe einer Fläche $A(\vec{x},t)$ ist, die in dem Kanal sich erstreckt und auf den zwei den Kanal (3) begrenzenden Schaufeloberflächen senkrecht zu diesen Schaufeloberflächen und dazwischen senkrecht zu den Strömungslinien angeordnet ist, wobei $\vec{x}$ eine Koordinate auf einer der zwei Schaufeloberflächen, t die Zeit, $p_0(\vec{x})$ der ortsabhängige Druck bei still stehenden Schaufelprofilen und $p_{ges}(\vec{x},t)$ der ortsabhängige Gesamtdruck ist;
   d) Verändern des geometrischen Modells und ermitteln einer veränderten Schwingungsform für das veränderte geometrische Modell sowie Durchführen von Schritt c) mit dem veränderten geometrischen Modell und der veränderten Schwingungsform;
   e) Bestimmen der Dämpfung der Schwingung durch den in Schritt d) berechneten Störddruckverlauf $p(\vec{x},t)$ und Akzeptieren des veränderten geometrischen Modells für den Fall, dass die Dämpfung der Schwingung stärker als in Schritt c) ausfällt, ansonsten Wiederholen der Schritte d) und e) mit einem anderen veränderten geometrischen Modell.

2. Verfahren gemäß Anspruch 1, mit dem Schritt:
   f) Numerisches Berechnen der anhand einer Strömung hervorgerufenen Schwingung des in Schritt e) akzeptierten geometrischen Modells und Berechnen der Dämpfung der Schwingung.

3. Verfahren gemäß Anspruch 2, wobei in Schritt f) die Konvektion und die Trägheit der Strömung berücksichtigt werden.

4. Verfahren gemäß einem der Ansprüche 1 bis 3, wobei die Schwingungsform in komplexer Form dargestellt wird: $\vec{\phi} = \vec{a}_c + i\vec{a}_s$, wobei $\vec{\phi}$ die Schwingungsform ist, $\vec{a}_c$ und $\vec{a}_s$ lokale Verformungen sind.

5. Verfahren gemäß Anspruch 4, wobei $\vec{a}_c$ und $\vec{a}_s$ mittels eines Finiten Elemente Strukturlösers bereitgestellt werden.

6. Verfahren gemäß Anspruch 4 oder 5, wobei $A(\vec{x},t)$ dargestellt wird gemäß $A(\vec{x},t) = A_0(\vec{x}) + \text{Re} \lfloor (\hat{A}_1 e^{i\beta_1} e^{i\sigma} + \hat{A}_R e^{i\beta_R}) e^{i\omega t} \rfloor$, wobei $A_0(\vec{x})$ die Fläche $A(\vec{x},t)$ bei still stehenden Schaufelprofilen, $\hat{A}_R = |\vec{n}_R \cdot \vec{\phi}|_R$ die Projektion der Schwingungsform auf die Normale $\vec{n}_R$ der Schaufeloberfläche bei der Koordinate $\vec{x}$ für das eine Schaufelprofil, $\hat{A}_1 = |\vec{n}_1 \cdot \vec{\phi}|_1$ die Projektion der Schwingungsform auf die Normale $\vec{n}_1$ der Schaufeloberfläche bei einem Punkt auf der Schaufeloberfläche des anderen Schaufelprofils, $\beta_1$ und $\beta_R$ der jeweilige Phasenversatz zwischen dem Imaginärteil und dem Realteil, $\sigma$ der Phasenversatz der Schwingungen der beiden Schaufelprofile und $\omega$ die Kreisfrequenz ist.

**7.** Verfahren gemäß Anspruch 6,
wobei $A_0(\vec{x})$ bestimmt wird, indem bei der Koordinate $\vec{x}$ auf der Schaufeloberfläche des einen Schaufelprofils ein Kreis (12) gefunden wird, der die Schaufeloberfläche des einen Schaufelprofils bei der Koordinate $\vec{x}$ und die Schaufeloberfläche des anderen Schaufelprofils in dem Punkt tangiert, und $A_0(\vec{x})$ derart gewählt wird, dass $A_0(\vec{x})$ von der Normalen $\vec{n}_R$ bei der Koordinate $\vec{x}$ und von der Normalen $\vec{n}_1$ an dem Punkt tangiert wird.

**8.** Verfahren gemäß Anspruch 7,
wobei $A_0(\vec{x})$ bestimmt wird durch Interpolieren einer Funktion, insbesondere ein Polynom zweiten Grades, zwischen der Koordinate $\vec{x}$ und dem Punkt.

**9.** Verfahren gemäß einem der Ansprüche 6 bis 8,
wobei in Schritt d) die Dämpfung der Schwingung für verschiedene Werte für $\beta_1$, $\beta_R$ und $\sigma$ bestimmt wird.

**10.** Verfahren gemäß einem der Ansprüche 1 bis 9,
wobei in Schritt d) eine Integration des ortsabhängigen Störddrucks entlang des vollständigen Kanals (3) vorgenommen wird.

**Claims**

**1.** Method for profiling blades of an axial turbomachine having the steps of:

a) preparing a geometric model of a blade profile (R, -1, +1);
b) determining an oscillation mode of the geometric model;
c) calculating a time profile of a position-dependent disruptive pressure $p(\vec{x},t==p_{ges}(\vec{x},t)-p_0(\vec{x})$ in a channel (3) between two adjacent blade profiles over an oscillation period of the oscillation belonging to the oscillation mode, wherein in order to calculate the profile it is assumed that the position-dependent disruptive pressure $p(\vec{x},t)$ in the channel (3) is proportional to the magnitude of a surface $A(\vec{x},t)$ which extends in the channel and is arranged perpendicular to the flow lines between the two blade surfaces bounding the channel (3), and perpendicular to these blade surfaces, wherein $\vec{x}$ is a coordinate on one of the two blade surfaces, t is time, $p_0(\vec{x})$ is the position-dependent pressure when the blade profiles are stationary, and $p_{ges}(\vec{x},t)$ is the position-dependent total pressure;
d) changing the geometric model and determining a different oscillation mode for the modified geometric model, as well as carrying out step c) with the modified geometric model and the different oscillation mode;
e) determining the damping of the oscillation using the disruptive pressure profile $p(\vec{x},t)$ calculated in step d) and accepting the modified geometric model for the case that the damping of the oscillation turns out to be greater than in step c), otherwise repeating steps d) and e) with another modified geometric model.

**2.** Method according to Claim 1, having the step of:
f) numerically calculating the oscillation, engendered by a flow, of the geometric model accepted in step e) and calculating the damping of the oscillation.

**3.** Method according to Claim 2,
wherein the convection and the inertia of the flow are taken into account in step f).

**4.** Method according to one of Claims 1 to 3,
wherein the oscillation mode is represented in complex form: $\vec{\phi} = \vec{a}_c + i\vec{a}_s$, wherein $\vec{\phi}$ is the oscillation mode, $\vec{a}_c$ and $\vec{a}_s$ are local deformations.

**5.** Method according to Claim 4,
wherein $\vec{a}_c$ and $\vec{a}_s$ are prepared by means of a finite element structure solver.

**6.** Method according to Claim 4 or 5,
wherein $A(\vec{x},t)$ is illustrated according to $A(\vec{x},t) = A_0(\vec{x}) + \mathrm{Re}\llcorner(\hat{A}_1 e^{i\beta_1}e^{i\sigma} + \hat{A}_R e^{i\beta_R})e^{i\omega t}\lrcorner$, wherein $A_0(\vec{x})$ is the area $A(\vec{x},t)$ when the blade profiles are stationary, $\hat{A}_R = |\vec{n}_R\cdot\vec{\phi}|_s$ is the projection of the oscillation mode onto the normal $\vec{n}_R$ to the blade surface at the coordinate $\vec{x}$ for the one blade profile, $\hat{A}_1 = |\vec{n}_1\cdot\vec{\phi}|_1$ is the projection of the oscillation mode onto the normal $\vec{n}_1$ to the blade surface at a point on the blade surface of the other blade profile, $\beta_1$ and $\beta_R$ are the relative phase offset between the imaginary component and the real component, $\sigma$ is the phase offset of the oscillations of the two blade profiles, and $\omega$ is the angular frequency.

**7.** Method according to Claim 6,
wherein $A_0(\vec{x})$ is determined in that a circle (12) is found on the blade surface of the one blade profile at the coordinate $\vec{x}$ which is tangential to the blade surface of the one blade profile at the coordinate $\vec{x}$ and the blade surface of the other blade profile at the point, and $A_0(\vec{x})$ is selected in such a way that $A_0(\vec{x})$ is tangential to the normal $\vec{n}_R$ at the coordinate $\vec{x}$ and to the normal $\vec{n}_1$ at the point.

**8.** Method according to Claim 7,
wherein $A_0(\vec{x})$ is determined through an interpolation of a function, in particular a second-order polynomial, between the coordinate $\vec{x}$ and the point.

9. Method according to one of Claims 6 to 8, wherein the damping of the oscillation is determined in step d) for different values of $\beta_1$, $\beta_R$ and $\sigma$.

10. Method according to one of Claims 1 to 9, wherein an integration of the position-dependent disruptive pressure is performed in step d) along the complete channel (3) .

**Revendications**

1. Procédé de profilage d'aubes d'une turbomachine axiale, comprenant les stades :

 a) on se procure un modèle géométrique d'un profil (R, -1, +1) d'aubes ;
 b) on détermine une forme d'oscillation du modèle géométrique ;
 c) on calcule une courbe en fonction du temps d'une pression de perturbation dépendant de l'emplacement $p(\vec{x},t) = p_{ges}(\vec{x},t) - p_0(\vec{x})$ dans un canal (3) entre deux profils d'aube voisins, sur une période de l'oscillation appartenant à la forme d'oscillation, dans lequel, pour le calcul de la courbe, on suppose que la pression $p(\vec{x},t)$ de perturbation dans le canal (3), est proportionnelle à la grandeur d'une surface $A(\vec{x}, t)$, qui s'étend dans le canal et sur les deux surfaces d'aube délimitant le canal (3), perpendiculairement à ces surfaces d'aube et entre elles perpendiculairement aux lignes de courant, $\vec{x}$ étant une coordonnée sur l'une des deux surfaces d'aube, t le temps, $p_0(\vec{x})$ la pression, qui dépend de l'emplacement pour des profils d'aube à l'arrêt, et $p_{ges}(\vec{x},t)$ la pression totale, qui dépend de l'emplacement ;
 d) on modifie le modèle géométrique et on détermine une forme d'oscillation modifiée du modèle géométrique modifié, ainsi que l'on effectue le stade c) avec le modèle géométrique modifié et la forme d'oscillation modifiée ;
 e) on définit l'amortissement de l'oscillation par la courbe $p(\vec{x},t)$ de pression de perturbation calculée au stade d) et on accepte le modèle géométrique modifié dans le cas où l'amortissement de l'oscillation est plus fort qu'au stade c), sinon, on répète les stades d) et e) avec un autre modèle géométrique modifié.

2. Procédé suivant la revendication 1, comprenant le stade :
 f) on calcule numériquement l'oscillation, provoquée à l'aide d'un écoulement, du modèle géométrique accepté au stade e) et on calcule l'amortissement de l'oscillation.

3. Procédé suivant la revendication 2, dans lequel, au stade f), on tient compte de la convexion et de l'inertie de l'écoulement.

4. Procédé suivant l'une des revendication 1 à 3, dans lequel on représente la forme d'oscillation sous une forme complexe : $\vec{\phi} = \vec{a}_c + i\vec{a}_s$, $\vec{\phi}$ étant la forme d'oscillation, $\vec{a}_c$ et $\vec{a}_s$ des déformations locales.

5. Procédé suivant la revendication 4, dans lequel on se procure $\vec{a}_c$ et $\vec{a}_s$ au moyen d'un résoluteur de structure aux éléments finis.

6. Procédé suivant la revendication 4 ou 5, dans lequel on représente $A(\vec{x},t)$ suivant $A(\vec{x},t) = A_0(\vec{x}) + \mathrm{Re}\,[(\hat{A}_1 e^{i\beta_1} e^{i\sigma} + \hat{A}_R e^{i\beta_R}) e^{i\omega t}]$, $A_0(\vec{x})$ étant la surface $A(\vec{x},t)$ pour des profils d'aube à l'arrêt, $\hat{A}_R + |\vec{n}_R \phi|_R$ la projection de la forme d'oscillation sur la normale $\vec{n}_R$ à la surface de l'aube à la coordonnée $\vec{x}$ pour le un profil d'aube, $\hat{A}_1 = |\vec{n}_R \phi|_1$ la projection de la forme d'oscillation sur la normale $\vec{n}_1$ de la surface de l'aube en un point sur la surface de l'aube de l'autre profil d'aube, $\beta_1$ et $\beta_R$ le déphasage respectif entre la partie imaginaire et la partie réelle, $\sigma$ le déphasage des oscillations des deux profils d'aube et $\omega$ la pulsation.

7. Procédé suivant la revendication 6, dans lequel on définit $A_0(\vec{x})$, en trouvant à la coordonnée $\vec{x}$ sur la surface de l'aube du un profil d'aube, un cercle (12), qui est tangent à la surface d'aube du un profil d'aube à la coordonnée $\vec{x}$ et à la surface d'aube de l'autre profil d'aube au point, et on choisit $A_0(\vec{x})$ de manière à ce que $A_0(\vec{x})$ soit tangent par la normale $\vec{n}_R$ à la coordonnée $\vec{x}$ et par la normale $\vec{n}_1$ au point.

8. Procédé suivant la revendication 7, dans lequel on définit $A_0(\vec{x})$ par interpolation d'une fonction, notamment d'un polynôme du deuxième degré, entre la coordonnée $\vec{x}$ et le point.

9. Procédé suivant l'une des revendications 6 à 8, dans lequel, dans le stade d), on définit l'amortissement de l'oscillation pour diverses valeurs de $\beta_1$, $\beta_R$ et $\sigma$.

10. Procédé suivant l'une des revendications 1 à 9, dans lequel, dans le stade d), on effectue une intégration de la pression de perturbation, qui dépend de l'emplacement, le long de tout le canal (3).

FIG 1

FIG 2

## FIG 3

## FIG 4

# FIG 5

EP 3 426 895 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1528223 A2